# EUROPEAN PATENT SPECIFICATION

(11) **EP 1 575 163 B1**
(45) Date of publication and mention of the grant of the patent: **10.10.2012**
(21) Application number: 05005283.6
(22) Date of filing: 10.03.2005
(51) Int. Cl.: H03G 3/32, H03G 5/16

(54) **Automobile audio system and signal processing method therefor**
Verfahren zur Verarbeitung von Tonsignalen für ein Automobil und System zur Durchführung des Verfahrens
Procédé de traitement de signaux sonores pour une automobile et système de mise en oeuvre du procédé

(30) Priority: 10.03.2004 JP 2004067798; 18.01.2005 JP 2005010353
(43) Date of publication of application: 14.09.2005
(73) Proprietor: YAMAHA CORPORATION, Hamamatsu-shi Shizuoka-ken (JP)
(72) Inventor: Honji, Yoshikazu, Hamamatsu-shi Shizuoka-ken (JP); Kobayashi, Tetsu, Hamamatsu-shi Shizuoka-ken (JP); Kunii, Takashi, Hamamatsu-shi Shizuoka-ken (JP)
(74) Representative: Wagner, Karl H.

(56) References cited:
- EP-A- 0 669 711
- EP-A- 0 899 164
- DE-A1- 10 140 407
- US-A- 4 641 344
- US-A- 5 483 692
- US-A- 5 635 903
- US-A- 5 907 622

## Description

### BACKGROUND OF THE INVENTION

The present invention relates to an automobile audio system installed into an automobile, and a signal processing method applied to the same.

The noise insulation is applied to the interior of the automobile by using the noise insulation material, but various noises such as engine noise, tire noise, wind noise, and so on are made during the driving and these noises are changed variously according to the driving conditions such as driving speed, engine speed, etc. As a result, such problems existed that the audio sound is masked with the noises at the time the automobile is running at a high speed and thus the user cannot hear such audio sound even when the audio signal of the automobile audio system such as the automobile stereo system, or the like is played at a suitable volume at the time the automobile is stopped. Conversely the volume of the audio sound becomes too large even when such volume suitable at the time the automobile is running at a high speed.

Therefore, in the related art, the automobile audio system for adjusting automatically the volume, or the like in response to the running state of the automobile was proposed (for example, JP-A-9-23495 and JP-A-2000-307366).

The system set forth in JP-A-9-23495 detects a speed pulse indicating a driving speed of the automobile and then adjusts an output of a sub-woofer that outputs a low-pitched sound in response to the driving speed. The system set forth in JP-A-2000-301366 controls the volume in response to the engine speed.

However, the systems set forth in both JP-A-9-23495 and JP-A-2000-307366 perform the volume control simply in response to the speed or the engine speed. Therefore, there existed a problem that the proper control that can respond to the noise generating situations in the vehicle interior under various driving conditions (for example, the case where the engine speed is high on an upward slope but the speed is slow, the case where the engine speed is low on a downward slope but the speed is high, or the like) cannot be performed. Also, the systems set forth in both Literatures perform the control that merely adjusts the volume (even though the bandwidth is limited into a low tone range and a high tone range respectively). Therefore, there existed another problem that the sound is amplified as a whole, but the compass that is masked with the noises is not compensated to hear clearly and thus articulation and intelligibility cannot be so improved though the volume is turned up.

Similarly to the above, US-A-5,907,622 discloses an audio signal processing system which produces an acoustic signal in a listening space and includes devices for generating a desired volume signal, a noise signal representative of ambient noise conditions in the listening space, and an audio signal. The system further includes a variable gain amplifier for amplifying the audio signal in response to a gain control signal and a device for generating the gain control signal in response to a volume control signal. The volume control signal is generated in response to the noise and desired volume signals so that the volume control signal increases in response to increases in the noise signal. The volume control signal increases at a rate of increase and the rate of increase decreases as the volume control signal increases.

Finally, US-A-4,641,344 discloses audio equipment designed for use at widely varying ambient noise levels which allows an audio signal to be amplified to enhanced levels under noisy conditions without added distortion near the high-amplitude end of its dynamic range. Detected or anticipated ambient noise conditions trigger a dynamic range controller to boost the gain of the audio signal to an extent inversely related to the audio signal amplitude. Thus, low-volume audio will be boosted to a great extent while the high-volume end of the dynamic range will experience little or no additional gain. The net effect is two allowable dynamic ranges, both sharing the same high-end volume level but with possibly widely different low-end volume levels. This gain and dynamic range control may also be performed independently on a number of discrete frequency bands. In addition, noise components inherent to the audio signal may be filtered to ambient noise-dependent extents, or the gain boost may be inhibited at volume levels susceptible to such noise.

### SUMMARY OF THE INVENTION

It is an object of the present invention to provide an automobile audio system capable of controlling an audio signal to hear clearly the signal even in any driving conditions and a signal processing method applied to the same.

According to the present invention, there is provided an automobile audio system as set forth in claim 1 and a signal processing method of an automobile audio system as set forth in claim 5. Preferred embodiments of the present invention may be gathered from the dependent claims.

In the present invention, the noises in the interior of the automobile at that time are estimated based on the sensed values of a plurality of sensors that sense the driving conditions. Since the noises are estimated based on the sensed values of the sensors that sense the driving conditions in this manner, processes of collecting the sounds in the vehicle interior by the microphones, then picking up only the noise component by separating the audio signal from the sound signal, then applying the frequency analysis, etc. are omitted, and thus the noise sensing (estimating) process can be simplified. Then, the masking characteristic with the noises is deduced, and then the equalizing characteristic that prevents the masking of the audio signal is decided based on the masking characteristic. If the audio signal is equalized based on the equalizing characteristic, the audio signal can be output even in any driving conditions in such a manner that the excessive volume is not brought about and the user can hear clearly the audio signal.

The process of estimating the noises in the interior of the automobile at that time based on the sensed values of a plurality of sensors, the process of deducing the masking characteristic with the estimated noises, and the process of deciding the equalizing characteristic based on the deduced masking characteristic to avoid the masking of the audio signal may be executed in real time every time when the sensor outputs are read. In this case, the processes of estimating the noises in the interior of the automobile at that time with respect to the combinations of the sensed values of a plurality of sensors, then deducing the masking characteristic with the estimated noises, and then deciding the equalizing characteristic based on the deduced masking characteristic not to mask the audio signal may be executed previously, and then the derived equalizing characteristics may be stored in the storage. Thus, the equalizing process can be executed during the operation of the automobile audio system by reading the equalizing characteristic based on the sensed values of a plurality of sensors. As a result, the processes in the system can also be simplified.

As described above, according to the present invention, the noises in the interior of the automobile are estimated in response to the driving conditions and then the audio signal is subjected to the equalizing process such that the audio signal is not masked with the noises. Therefore, the volume is not excessively changed rather than the case where the volume is turned up or down simply in response to the speed or the engine speed, and also articulation and intelligibility can be improved.

### BRIEF DESCRIPTION OF THE DRAWINGS

FIG.1 is a block diagram of an automobile audio system as an embodiment of the present invention.
FIG.2 is a view showing a configuration of a noise estimation database of the same automobile audio system.
FIG.3 is a flowchart showing processing procedures in a control portion of the same automobile audio system.
FIG.4 is a flowchart showing another mode of processing procedures in the control portion of the same automobile audio system.

### DETAILED DESCRIPTION OF PREFERRED EMBODIMENTS

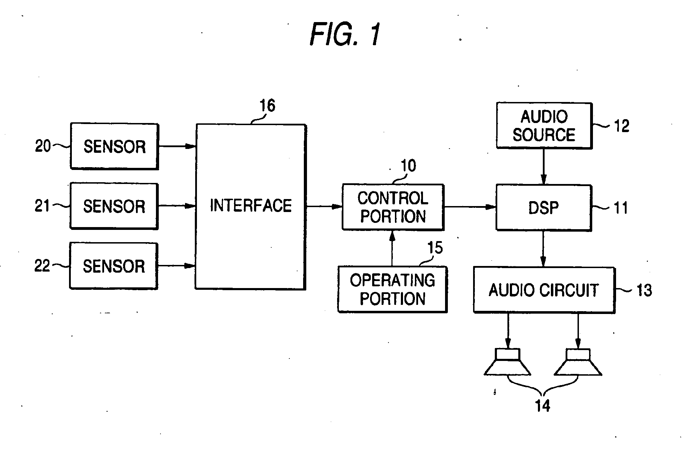

FIG.1 is a block diagram of an automobile audio system according to an embodiment of the present invention. A control portion 10 is provided with a microprocessor, and a ROM for storing programs and databases, a RAM as a working memory, various interfaces, etc. in addition to a CPU are built therein. As sensors for sensing the driving conditions, an engine speed sensor 20 for sensing an engine speed, an accelerator opening angle sensor 21 for sensing an opening angle of the accelerator, and a speed sensor 22 for sensing a speed of the automobile are connected to the control portion 10 via an interface 16. An A/D converter is built in the interface 16 as the case may be. When the engine speed sensor 20 and the speed sensor 22 are constructed by an encoder that outputs pulses in response to either the revolution of the engine or the revolution of the axle, the control portion 10 may calculate the number of revolution of the engine or the speed of the automobile based on an integrated value of these pulses or a pulse interval between them.

The control portion 10 reads periodically sensed values of the engine speed sensor sensors 20, the accelerator opening angle sensor 21, and the speed sensor 22, and then estimates the current noise in the interior of the automobile based on the sensed values. The estimation of the noise frequency characteristic is performed by searching a noise estimation database based on the sensed values of the sensors. The noise estimation database store noise characteristics which are data showing shapes of frequency spectrum of the noise. An equalizer characteristic for the audio signal is determined based on the estimated noise frequency characteristic so as to prevent the noise from masking the audio signal. Incidentally, at the time of determining the equalizer characteristic, the equalizer characteristic may be calculated after obtaining masking characteristic by the noise with taking hearing sense of a human being into account instead of estimating the noise frequency characteristic. In this case, the equalizer characteristic is determined by searching the masking characteristic database using the sensed values of each sensor, so that the audio signal can be heard without the read-out masking characteristic. A digital audio signal is input from an audio source 12 to the DSP 11. Incidentally, the noise characteristic stored in the noise estimation data base may be waveform database or parameters that approximates the shape if the data represents the shape of the frequency spectrum. As an example of the waveform data, plot data in which values are arranged at predetermined frequency interval on a frequency axis, and as an example of the parameters that represents a polynomial expression (function) approximating the shape of the frequency spectrum.

The digital audio signal is input from the audio source 12 to the DSP 11. The DSP 11 applies the equalizing process to the audio signal based on the equalizing characteristic that is input from the control portion 10. The audio signal output from the DSP 11 is input into an audio circuit 13. The audio circuit 13 includes a D/A converter and an audio amplifier, and D/A-converts the input audio signal and then amplifies the resultant signal. Then, the amplified signal is output from speakers 14 embedded on wall surfaces of the interior of the automobile respectively.

Therefore, the audio signal being output from the speakers 14 is subjected to the equalizing process in answer to the noises in the interior of the automobile. Thus, an articulation and an intelligibility of the audio signal can be enhanced not to turn up the volume as a whole at the time the automobile is running at a high speed.

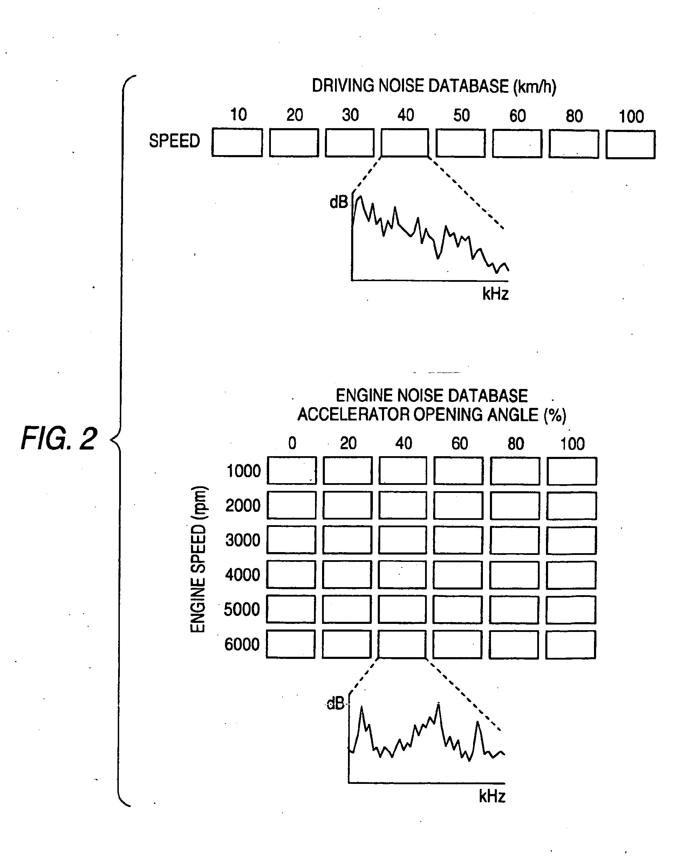

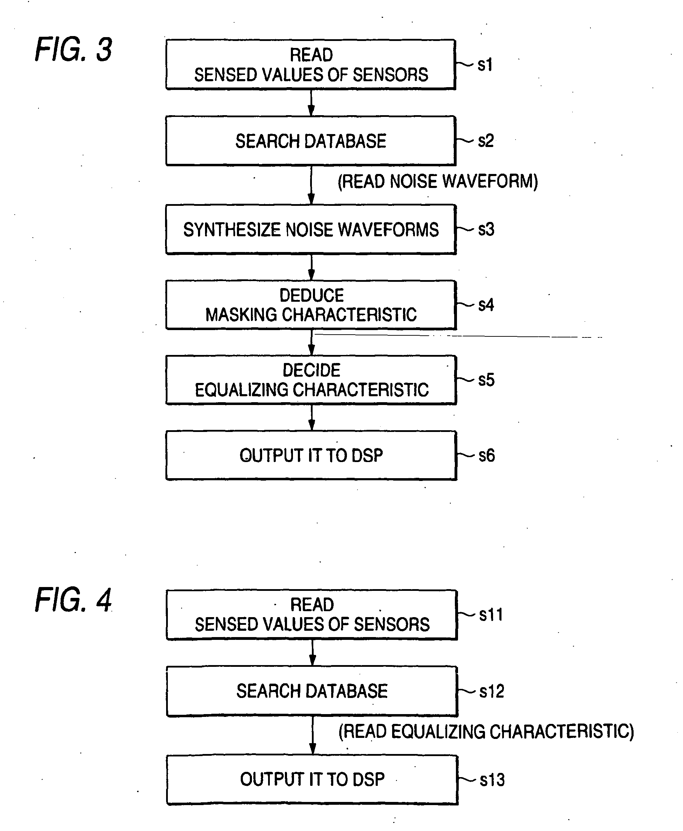

FIG.2 is a view showing a configuration of a noise estimation database of the same automobile audio system. FIG. 3 is a flowchart showing processing procedures in the control portion 10. In FIG.2, the noise estimation database is constituted of a driving noise database and an engine noise database. The driving noise database stores frequency characteristics of the driving noises (noises such as noises propagated from the road surface and the tire except the engine noise, noises such as a wind noise, etc.) in respective speed steps at 10, 20, 30, 40, 50, 60, 80, and 100 (km/h). The engine noise database stores frequency characteristics of the engine noise in respective combinations of accelerator opening angle steps of 0, 20, 40, 60, 80, and 100 (%) and engine speed steps of 1000, 2000, 3000, 4000, 5000, and 6000 (rpm).

Characteristic which is obtained by time averaging the frequency characteristic data measured at the time of actually driving the automobile may be employed as these noise frequency characteristics. But the noises measured in the normal driving must be separated into the driving noise and the engine noise. In order to measure separately the driving noise and the engine noise in advance, first the driving noise is measured by using the hauled vehicle whose engine is not run, and then the engine noise is measured by driving the vehicle on the chassis dynamo equipment. The driving noise and the engine noise may be separated with higher precision by comparing these measured results with the measured results at the time of actually driving the automobile. In addition, simulation results, wind tunnel measured results, etc. may be taken into consideration.

In FIG.3, sensed values of the engine speed sensors 20, the accelerator opening angle sensor 21, and the speed sensor 22 are read out (s1). A corresponding noise frequency characteristic is read by searching the noise estimation database in FIG. 2 based on the sensed values of the sensors (s2). If the speed, the accelerator opening angle, and the engine speed, all sensed, do not agree with the above steps in this reading, actual measured values are rounded off into any step by the process such as a rounding off, or the like. For example, when the speed is 47 km/h, the driving noise frequency characteristic corresponding to 50 km/h is read by applying a rounding off the speed. Also, when the accelerator opening angle is 15 % and the engine speed is 2300 rpm, the engine noise frequency characteristic corresponding to 20 %×2000 rpm that is closest to the above measured values is read. In s3, the noise in the interior of the automobile at that time is estimated by synthesizing the driving noise frequency characteristic and the engine noise frequency characteristic that were read. In s3, such a processing that the noise in interior of the vehicle is estimated only from the engine noise frequency characteristic may be performed.

Instead of reading out the sensed values in real time, the sensed values may be read out after performing the averaging process by the predetermined time interval. The corresponding noise frequency characteristic is read out based on the averaged sensed value. By averaging it in this manner, volume is not rapidly changed and the audio signal can be changed more naturally.

Incidentally, in the above embodiment, the engine noise frequency characteristic corresponding to the sensed values of the engine speed sensor 20, the accelerator opening angle sensor 21 is read out. However, the present invention is not limited thereto. The engine noise database that stores the engine noise frequency characteristic corresponding to the sensed value of the engine speed sensor 20 may filter the read-out engine noise frequency characteristic by a filtering characteristic corresponding to the accelerator opening angle sensor 21. The filtering characteristic may be read out from database that stores the filtering characteristics corresponding to the sensed values of the accelerator opening sensor, or may be calculated based on the sensed value of the accelerator opening sensor.

After this, the masking characteristic by the noise is determined based on the estimated noise characteristic (s4). Here, it is determined how the audio signal is masked by the estimated noise frequency characteristic. In the most simple manner, the noise frequency characteristic is regarded as the masking frequency characteristic. The equalizer characteristic is determined so as to prevent the audio signal being masked based on the masking characteristic (masking frequency characteristic) (S5). In the most simple manner, the equalizer characteristic is set to have a same characteristic as the noise frequency characteristic and increases a gain of the audio signal.

In this deduction of this masking characteristic, the frequency characteristic of the hearing sense of a human being, masking characteristics of harmonics, and the like may be considered together in addition to the synthesized noise waveform. A temporal masking characteristic derived based on the past noise waveform as well as the frequency masking characteristic derived based on the current noise waveform may be considered together. The temporal masking is a masking on a time axis, and is such a hearing sense characteristic of the human being that when a short sound is generated immediately after certain sound is stopped being generated, for example, the short sound is drown out by the certain sound. Hence, after detecting a high noise level, the gain of the audio signal is set high for a predetermined period so as to prevent the audio signal from being masked on the time axis.

In the equalizing process, if a gain in a frequency range in which a noise level is high is not increased but a gain in a frequency range in which a noise level is slightly lower than the above frequency range in which the noise level is high is increased, an articulation and an intelligibility can be enhanced while suppressing the entire volume. When a frequency band in which the noise level is high is a low frequency band, a masking of a frequency higher than said frequency is taken into account to adjust the equalizer characteristic. On the other hand, when a frequency band in which the noise level high is a high frequency band, the equalizer characteristic is adjusted without taking into account the masking of a frequency lower than said frequency since the audio signal of low frequency is hard to be masked by the noise of high frequency band. In this manner, an articulation and an intelligibility can be enhanced while suppressing the entire volume.

This equalizing characteristic determined in the above manner is output to the DSP 11 to apply the equalizing process to the audio signal that was input from the audio source 12 (s6).

The above explanation is made of the embodiment in which the estimation of the noise waveform → the deduction of the masking characteristic → the decision of the equalizing characteristic are determined in real time in response to the sensed values of the sensors. The automobile audio system according to the present invention can be modified as follows.

Namely, if calculating processes applied to the estimation of the noise waveform → the deduction of the masking characteristic → the decision of the equalizing characteristic are carried out previously as with all combinations of the speed step, the accelerator opening angle step, and the engine speed step and then the calculated equalizing characteristics that are correlated with the combinations of the speed step, the accelerator opening angle step, and the engine speed step respectively are stored in the memory as an equalizing characteristic database, the equalizing characteristic can be decided only by searching the database based on the sensed values of the sensors during the actual operation of the automobile audio system. In this case, since it is difficult to consider a change of the noise in a time series, it is preferable that the equalizing characteristic that takes account of the frequency masking only should be employed.

FIG.4 is a flowchart showing processing procedures in the processing portion that stores the equalizing characteristic database. The sensed values are read from the engine speed sensor 20, the accelerator sensor 21 and the speed sensor 22 (s11). The corresponding equalizing characteristic is read by searching the equalizing characteristic database based on the combination of the sensed values of the sensors (s12). Then, this equalizing characteristic is output to the DSP 11 (s13). As a result, the equalization of the audio signal can be attained by the processes that are more simple than those in FIG.3. Incidentally, only the sensed values of the engine speed sensor 20 and the accelerator opening angle 21 may be used for the retrieval key of the equalizer database without considering the sensed value of the speed sensor 22.

## Claims

1. An automobile audio system comprising:
a plurality of sensors (20, 21, 22) adapted to sense driving conditions of an automobile wherein the plurality of sensors (20, 21, 22) includes an engine speed sensor (20) adapted to sense an engine speed and an accelerator opening angle sensor (21) adapted to sense an accelerator opening angle;
a noise database configured to store noise characteristics corresponding to the plurality of sensors (20, 21, 22), wherein the noise database includes an engine noise database configured to store engine noise characteristics of an engine noise component contained in the noise of the interior,
an estimating unit (10) configured to estimate noises in an interior of the automobile based on sensed values of the plurality of sensors, wherein the estimating unit (10) is configured to read out the noise characteristic corresponding to the sensed values of the plurality of sensors (20, 21, 22) to estimate the noise, wherein the estimating unit (10) is configured to read out the engine noise characteristic corresponding to the sensed value of the engine speed sensor (20), and filters the engine noise characteristic corresponding to the sensed value of the engine speed sensor (20) with a filter characteristic corresponding to the sensed value of the accelerator opening angle sensor (21) to estimate the noise characteristic;
a determining unit (10) configured to determine an equalizing characteristic based on the estimated noises so that an audio signal is not masked; and
a signal processing portion (11) adapted to receive the audio signal and to execute a signal processing based on the determined equalizing characteristic.

2. The automobile audio system according to claim 1, wherein
the plurality of sensors (20, 21, 22) further includes a speed sensor (22) adapted to sense a speed of the automobile,
the noise database further includes a driving noise database configured to store driving noise characteristics of a driving noise component contained in the noise of the interior, and
the automobile audio system further comprises a synthesizing unit adapted to synthesize the engine noise characteristic corresponding to the sensed values of the engine speed sensor (20) and the accelerator opening angle sensor (21) and the driving noise characteristic corresponding to the sensed value of the speed sensor (22) to generate a noise characteristic of the interior.

3. The automobile audio system according to claim 1 further comprising a sensed value averaging unit configured to average the sensed value of the plurality of sensors by a predetermined time interval, and
wherein the estimating unit (10) is configured to estimate the noise based on the sensed value averaged by the sensed value averaging unit.

4. The automobile audio system according to any of the preceding claims, wherein the signal processing portion (11) is configured to set a gain of the audio signal high for a predetermined period when the noise estimated by the estimating unit (10) has a high noise level.

5. A signal processing method of an automobile audio system, the method comprising:
estimating noises of an interior of an automobile based on sensed values of a plurality of sensors (20, 21, 22) that sense driving conditions of the automobile wherein the plurality of sensors (20, 21, 22) includes an engine speed sensor (20) sensing an engine speed and an accelerator opening angle sensor (21) sensing an accelerator opening angle, wherein said estimating includes reading out a noise characteristic from a noise database that stores noise characteristics corresponding to the plurality of sensors (20, 21, 22), wherein the noise database includes an engine noise database that stores engine noise characteristics of an engine noise component contained in the noise of the interior, said noise characteristic corresponding to the sensed values of the plurality of sensors (20, 21, 22) to estimate the noise, wherein said estimating includes reading out the engine noise characteristic corresponding to the sensed value of the engine speed sensor (20), and filters the engine noise characteristic corresponding to the sensed value of the engine speed sensor (20) with a filter characteristic corresponding to the sensed value of the accelerator opening angle sensor (21) to estimate the noise characteristic; and
determining an equalizer characteristic based on the estimated noises for avoiding the audio signal having a frequency which is higher than a frequency band in which the estimated noise level is high being masked; and
receiving the audio signal and executing a signal processing based on the determined equalizing characteristic.

6. The signal processing method of claim 5, wherein when the estimated noise has a high noise level, a gain of the audio signal is set high for a predetermined period.

## Patentansprüche

1. Audiosystem für ein Automobil, das Folgendes aufweist:
Eine Vielzahl von Sensoren (20, 21, 22), die angepasst ist, um die Antriebszustände eines Automobils abzufühlen, wobei die Vielzahl der Sensoren (20, 21, 22) einen Motordrehzahlsensor (20) umfasst, der angepasst ist, um eine Motordrehzahl abzufühlen, sowie einen Öffnungswinkelsensor (21) für das Gaspedal bzw. den Beschleuniger, der angepasst ist, um den Beschleunigeröffnungswinkel abzufühlen;
eine Geräuschdatenbank, die konfiguriert ist, um Geräuschcharakteristiken zugehörig zu der Vielzahl von Sensoren (20, 21, 22) zu speichern, wobei die Geräuschdatenbank eine Motorgeräuschdatenbank umfasst, die konfiguriert ist, um Motorgeräuschcharakteristiken einer Motorgeräuschkomponente zu speichern, die im Geräusch des Innenraums enthalten ist,
eine Schätzeinheit (10), die konfiguriert ist, um Geräusche in einem Innenraum des Automobils zu schätzen, und zwar basierend auf den abgefühlten Werten der Vielzahl von Sensoren, wobei die Schätzeinheit (10) konfiguriert ist, um die Geräuschcharakteristik zugehörig zu dem abgefühlten Werten der Vielzahl von Sensoren (20, 21, 22) auszulesen, um das Geräusch zu schätzen, wobei die Schätzeinheit (10) konfiguriert ist, um die Motorgeräuschcharakteristik zugehörig zu dem abgefühlten Wert des Motordrehzahlsensors (20) auszulesen, und die Motorgeräuschcharakteristik zugehörig zu dem abgefühlten Wert des Motordrehzahlsensors (20) mit einer Filtercharakteristik zugehörig zu dem abgefühlten Wert des Öffnungswinkelsensors (21) des Beschleunigers filtert, um die Geräuschcharakteristik zu schätzen;
eine Bestimmungseinheit (10), die konfiguriert ist, um eine Entzerrungscharakteristik basierend auf den geschätzten Geräuschen zu bestimmen, so dass ein Audiosignal nicht maskiert wird; und
einen Signalverarbeitungsteil (11), der angepasst ist, um das Audiosignal zu empfangen und um eine Signalverarbeitung basierend auf der bestimmten Entzerrungscharakteristik auszuführen.

2. Audiosystem für ein Automobil gemäß Anspruch 1, wobei
die Vielzahl von Sensoren (20, 21, 22) ferner einen Geschwindigkeitssensor (22) aufweist, der angepasst ist, um eine Geschwindigkeit des Automobils abzufühlen,
die Geräuschdatenbank ferner eine Antriebsgeräuschdatenbank umfasst, die konfiguriert ist, um Antriebsgeräuschcharakteristiken einer Antriebsgeräuschkomponente zu speichern, die in dem Geräusch des Innenraums enthalten ist, und
das Audiosystem des Automobils ferner eine Synthetisierungseinheit aufweist, die angepasst ist, um die Motorgeräuschcharakteristik zugehörig zu den abgefühlten Werten des Motordrehzahlsensors (20) und des Öffnungswinkelsensors (21) des Beschleunigers, und die Antriebsgeräuschcharakteristik zugehörig zu dem abgefühlten Wert des Drehzahlsensors (22) künstlich herzustellen bzw. zu synthetisieren, um eine Geräuschcharakteristik des Innenraums zu erzeugen.

3. Audiosystem für ein Automobil gemäß Anspruch 1, das ferner eine Durchschnittsbildungseinheit für die abgefühlten Werte aufweist, die angepasst ist, um Durchschnitte für die abgefühlten Werte der Vielzahl von Sensoren über ein vorbestimmten Zeitintervall hinweg zu bilden, und
wobei die Schätzeinheit (10) konfiguriert ist, um das Geräusch basierend auf dem abgefühlten Wert, dessen Durchschnitt durch die Durchschnittsbildungseinheit der abgefühlten Werte ermittelt wurde, zu schätzen.

4. Audiosystem für ein Automobil gemäß einem der vorangehenden Ansprüche, wobei der Signalverarbeitungsteil (11) konfiguriert ist, um eine Verstärkung des Audiosignals für eine vorbestimmte Zeitdauer hoch einzustellen, wenn das Geräusch, das durch die Schätzeinheit (10) geschätzt wird, einen hohen Geräuschpegel besitzt.

5. Signalverarbeitungsverfahren für ein Audiosystem eines Automobils, wobei das Verfahren Folgendes aufweist:
Schätzen der Geräusche eines Innenraums eines Automobils basierend auf den abgefühlten Werten einer Vielzahl von Sensoren (20, 21, 22), die Antriebsbedingungen des Automobils abfühlen, wobei die Vielzahl von Sensoren (20, 21, 22) einen Motordrehzahlsensor (20), der eine Motordrehzahl abfühlt und einen Öffnungswinkelsensor (21) eines Gaspedals bzw. Beschleunigers aufweist, der einen Beschleunigeröffnungswinkel abfühlt, wobei das Schätzen das Auslesen einer Geräuschcharakteristik aus einer Geräuschdatenbank umfasst, die Geräuschcharakteristiken zugehörig zu der Vielzahl von Sensoren (20, 21, 22) speichert, wobei die Geräuschdatenbank eine Motorgeräuschdatenbank umfasst, die Motorgeräuschcharakteristiken einer Motorgeräuschkomponente speichert, die in dem Geräusch des Innenraums enthalten ist, wobei die Geräuschcharakteristik zugehörig zu den abgefühlten Werten der Vielzahl von Sensoren (20, 21, 22) verwendet wird, um das Geräusch zu schätzen, wobei das Schätzen das Auslesen der Motorgeräuschcharakteristik zugehörig zu den abgefühlten Werten des Motordrehzahlsensors (20) aufweist und die Motorgeräuschcharakteristik zugehörig zu dem abgefühlten Wert des Motordrehzahlsensors (20) mit einer Filtercharakteristik zugehörig zu dem abgefühlten Wert des Öffnungswinkelsensors (21) des Beschleunigers filtert, um die Geräuschcharakteristik zu schätzen; und
Bestimmen einer Entzerrungscharakteristik basierend auf den geschätzten Geräuschen, um zu verhindern, dass das Audiosignal, das eine Frequenz besitzt, die höher als ein Frequenzband ist, in dem der geschätzte Geräuschpegel hoch ist, maskiert wird; und
Empfangen eines Audiosignals und Ausführen einer Signalverarbeitung basierend auf der bestimmten Entzerrungscharakteristik.

6. Signalverarbeitungsverfahren gemäß Anspruch 5, wobei wenn das geschätzte Geräusch einen hohen Geräuschpegel aufweist, eine Verstärkung des Audiosignals für eine vorbestimmte Zeitdauer hoch eingestellt wird.

## Revendications

1. Système audio d'automobile comprenant :
une pluralité de capteurs (20, 21, 22) conçus pour détecter des conditions de conduite d'une automobile, dans lequel la pluralité de capteurs (20, 21, 22) comprend un capteur de vitesse de moteur à combustion interne (20) conçu pour détecter une vitesse de moteur à combustion interne et un capteur d'angle d'ouverture d'accélérateur (21) conçu pour détecter un angle d'ouverture d'accélérateur ;
une base de données de bruits configurée pour mémoriser des caractéristiques de bruits correspondant à la pluralité de capteurs (20, 21, 22), dans lequel la base de données de bruits comprend une base de données de bruits de moteur à combustion interne configurée pour mémoriser les caractéristiques de bruit de moteur à combustion interne d'une composante de bruit de moteur à combustion interne contenue dans le bruit à l'intérieur,
une unité d'estimation (10) configurée pour estimer des bruits à l'intérieur de l'automobile sur la base des valeurs détectées de la pluralité de capteurs, dans lequel l'unité d'estimation (10) est configurée pour extraire la caractéristique de bruit correspondant aux valeurs détectées de la pluralité de capteurs (20, 21, 22) pour estimer le bruit, dans lequel l'unité d'estimation (10) est configurée pour extraire la caractéristique de bruit de moteur à combustion interne correspondant à la valeur détectée du capteur de vitesse de moteur à combustion interne (20), et filtre la caractéristique de bruit de moteur à combustion interne correspondant à la valeur détectée du capteur de vitesse de moteur à combustion interne (20) avec une caractéristique de filtrage correspondant à la valeur détectée du capteur d'angle d'ouverture d'accélérateur (21) pour estimer la caractéristique de bruit ;
une unité de détermination (10) configurée pour déterminer une caractéristique d'égalisation sur la base des bruits estimés de sorte qu'un signal audio n'est pas masqué ; et
une partie de traitement de signal (11) conçue pour recevoir le signal audio et pour exécuter un traitement de signal sur la base de la caractéristique d'égalisation déterminée.

2. Système audio d'automobile selon la revendication 1, dans lequel
la pluralité de capteurs (20, 21, 22) comprennent en outre un capteur de vitesse (22) conçu pour détecter une vitesse de l'automobile,
la base de données de bruits comprend en outre une base de données de bruits de conduite configurée pour mémoriser les caractéristiques de bruit de conduite d'une composante de bruit de conduite contenue dans le bruit à l'intérieur, et
le système audio d'automobile comprend en outre une unité de synthèse conçue pour synthétiser la caractéristique de bruit de moteur à combustion interne correspondant aux valeurs détectées du capteur de vitesse de moteur à combustion interne (20) et du capteur d'angle d'ouverture d'accélérateur (21) et la caractéristique de bruit de conduite correspondant à la valeur détectée du capteur de vitesse (22) pour générer une caractéristique de bruit à l'intérieur.

3. Système audio d'automobile selon la revendication 1, comprenant en outre une unité de moyennage de valeur détectée configurée pour moyenner la valeur détectée de la pluralité de capteurs sur un intervalle de temps prédéterminé, et
dans lequel l'unité d'estimation (10) est configurée pour estimer le bruit sur la base de la valeur détectée moyennée par l'unité de moyennage de valeur détectée.

4. Système audio d'automobile selon l'une quelconque des revendications précédentes, dans lequel la partie de traitement de signal (11) est configurée pour fixer un gain du signal audio à une valeur élevée pendant une période prédéterminée lorsque le bruit estimé par l'unité d'estimation (10) a un niveau de bruit élevé.

5. Procédé de traitement de signal d'un système audio d'automobile, le procédé consistant à :
estimer les bruits à l'intérieur d'une automobile sur la base des valeurs détectées d'une pluralité de capteurs (20, 21, 22) qui détectent des conditions de conduite de l'automobile, dans lequel la pluralité de capteurs (20, 21, 22) comprennent un capteur de vitesse de moteur à combustion interne (20) détectant une vitesse de moteur à combustion interne et un capteur d'angle d'ouverture d'accélérateur (21) détectant un angle d'ouverture d'accélérateur, dans lequel ladite estimation comprend l'extraction d'une caractéristique de bruit d'une base de données de bruits qui mémorise des caractéristiques de bruits correspondant à la pluralité de capteurs (20, 21, 22), dans lequel la base de données de bruits comprend une base de données de bruits de moteur à combustion interne qui mémorise les caractéristiques de bruit de moteur à combustion interne d'une composante de bruit de moteur à combustion interne contenue dans le bruit à l'intérieur, ladite caractéristique de bruit correspondant aux valeurs détectées de la pluralité de capteurs (20, 21, 22) pour estimer le bruit, dans lequel ladite estimation consiste à extraire la caractéristique de bruit de moteur à combustion interne correspondant à la valeur détectée du capteur de vitesse de moteur à combustion interne (20), et à filtrer la caractéristique de bruit de moteur à combustion interne correspondant à la valeur détectée du capteur de vitesse de moteur à combustion interne (20) avec une caractéristique de filtrage correspondant à la valeur détectée du capteur d'angle d'ouverture d'accélérateur (21) pour estimer la caractéristique de bruit ; et
déterminer une caractéristique d'égaliseur sur la base des bruits estimés pour éviter que le signal audio ayant une fréquence qui est supérieure à une bande de fréquence dans laquelle le niveau de bruit estimé est élevé soit masqué ; et
recevoir le signal audio et exécuter un traitement de signal sur la base de la caractéristique d'égalisation déterminée.

6. Procédé de traitement de signal selon la revendication 5, dans lequel lorsque le bruit estimé a un niveau de bruit élevé, un gain du signal audio est fixé à un niveau élevé pendant une période prédéterminée.
